# EUROPÄISCHE PATENTANMELDUNG

(11) **EP 1 150 126 A2**
(43) Veröffentlichungstag der Anmeldung: **31.10.2001**
(21) Anmeldenummer: 01108727.7
(22) Anmeldetag: 06.04.2001
(51) Int. Cl.: G01R 15/06

(54) **Abgesicherter kapazitiver Teiler**

(30) Priorität: 29.04.2000 DE 10021124
(71) Anmelder: EFEN Elektrotechnische Fabrik GmbH, 65344 Eltville (DE)
(72) Erfinder: Klemme, Thomas, 65388 Schlangebad (DE); Hesse Martin, 65388 Schlangebad (DE); Gessner, Klaus-Dieter, 65195 Wiesbaden (DE); Bessei, Herbert, Dr.Ing., 65307 Bad Schwalbach (DE); Gockenbach, Ernst, Prof.Dr.Ing., 31303 Burgdorf (DE)
(74) Vertreter: Weber, Dieter, Dr.

(57) **Zusammenfassung**

Beschrieben wird ein kapazitiver Teiler mit zwei Anschlußkontakten (2) und einem Gehäuse (3), in welchem ein die beiden Anschlußkontakte (2) verbindendes kapazitives Bauelement (15) vorgesehen ist.

Um einen induktivitätsarmen, besonders kompakten und ebenso preisgünstigen kapazitiven Teiler mit hoher Kapazität zur Verfügung zu stellen, sieht die Erfindung vor, daß ein Verbindungsleiter (5) vorgesehen ist, der zumindest teilweise als Schmelzeliter (5) ausgebildet ist und der das kapazitive Bauelement (15) mit einem Anschlußkontakt (2) verbindet.

## Beschreibung

Die vorliegende Erfindung betrifft einen kapazitiven Teiler mit einem Gehäuse und zwei Anschlußkontakten, wobei ein die beiden Anschlußkontakte verbindendes kapazitives Bauelement vorgesehen ist.

Unter einem kapazitiven Bauelement wird im allgemeinen ein Kondensator verstanden, der in vielfältigen Ausführungsformen auf dem Markt erhältlich ist. Es versteht sich aber, daß prinzipiell anstelle des Kondensators auch jedes andere Bauteil verwendet werden kann, sofern es kapazitive Eigenschaften aufweist.

Solche kapazitiven Teiler der eingangs genannten Art sind allgemein bekannt. Sie dienen beispielsweise der Blindstromkompensation. Sie können aber auch an das Mittelspannungsverteilungsnetz zur Übertragung von Meßwerten und Signalen angeschlossen werden. So können mit Hilfe des kapazitiven Teilers transiente Vorgänge, wie z. B. kurzzeitige Überspannungen, leicht detektiert werden. Insbesondere zur Überwachung der Spannungsqualität werden die kapazitiven Teiler mit Erfolg eingesetzt. Überdies wird durch kapazitive Teiler die Übertragung von Strömen hoher Frequenz für die Übermittlung von Schaltsignalen, Steuersignalen oder Signalen der Datenkommunikation in analoger und digitaler Form möglich.

Bei einem bekannten kapazitiven Spannungsteiler sind zwei Elektroden (eine Außenelektrode und eine Innenelektrode) in einen Isolierstoff eingebettet. Dadurch ist die Gefahr eines Spannungsdurchschlages stark herabgesetzt. Nachteilig ist bei dem bekannten Spannungsteiler jedoch, daß die Anordnung nur eine relativ kleine Kapazität von etwa 10 pF aufweist, wodurch sich nur ein leistungsschwaches Übertragungssignal ergibt.

Es wurde auch schon versucht, bekannte Wickelkondensatoren als kapazitive Teiler zu verwenden. Diese haben jedoch den Nachteil, daß sie eine nicht zu vernachlässigende Eigeninduktivität aufweisen. Diese Eigeninduktivität ist aber, insbesondere bei der Verwendung des kapazitiven Teilers in Hochspannungsnetzen, unerwünscht.

Ebenso wurden bereits induktivitätsarme Scheibenkondensatoren in kapazitiven Teilern eingesetzt. Bei diesen Kondensatoren kann sich konstruktionsbedingt innerhalb des Dielektrikums eine sehr hohe Feldstärke ausbilden. Damit verbunden ist eine hohe Fehlerwahrscheinlichkeit. Der Nachteil eines elektrischen Ausfalls eines solchen kapazitiven Teilers kann beispielsweise durch mehrere redundante Komponenten weitgehend kompensiert werden. Dabei muß jedoch sichergestellt werden, daß durch einen Isolationsdurchschlag des Kondensators kein Kurzschluß des angeschlossenen Spannungsnetz auftritt.

Dies kann beispielsweise durch Verwendung einer kurzschlußstrombegrenzenden Schmelzsicherung in bekannter Weise verhindert werden. Bekannte Hochspannungs-Hochleistungssicherungen in der üblichen Bauform, z. B. nach VDE 0670 Teil 4, sind infolge ihrer Baugröße und der aufwendigen Ausführung als Sicherungsunterteil und Sicherungseinsatz jedoch zur Absicherung eines kapazitiven Spannungsteilers wirtschaftlich nicht sinnvoll. Zudem werden durch die zusätzliche Sicherung zusätzliche Verbindungsleitungen unumgänglich, die ebenfalls eine unerwünschte Eigeninduktivität aufweisen. Außerdem weisen auch die üblichen Sicherungen, da sie einen gewickelten Schmelzleiter beinhalten, eine nicht vernachlässigbare Induktivität auf.

Der vorliegenden Erfindung liegt daher die Aufgabe zugrunde, einen induktivitätsarmen, besonders kompakten und ebenso preisgünstigen kapazitiven Teiler mit hoher Kapazität zur Verfügung zu stellen.

Erfindungsgemäß wird diese Aufgabe bei einem kapazitiven Teiler mit einem Gehäuse und zwei Anschlußkontakten, wobei ein die beiden Anschlußkontakte verbindendes kapazitives Bauelement vorgesehen ist, dadurch gelöst, daß ein Verbindungsleiter vorgesehen ist, der zumindest teilweise als Schmelzleiter ausgebildet ist und der das kapazitive Bauelement mit einem Anschlußkontakt verbindet. Dieser Schmelzleiter dient als Sicherung, so daß die Kapazität des kapazitiven Bauelements deutlich erhöht werden kann, ohne daß bei einem Spannungsdurchschlag ein Netzkurzschluß mit sehr nachteiligen Folgen auftritt. Sollte es zu einem Spannungsdurchschlag kommen, so wird die Wärmeentwicklung im Schmelzleiter so groß, daß dieser durchschmilzt, wodurch der kapazitive Teiler sofort vom Netz getrennt wird. Durch die Erfindung ist es beispielsweise möglich, das kapazitive Bauelement direkt in das Sicherungsgehäuse einzusetzen, wodurch ein separates Bauteil und die notwendige Verbindungsleitung dazwischen eingespart werden.

Daher wird das Gehäuse vorzugsweise als Sicherungsgehäuse in Form eines als Hohlkörper ausgebildeten Isolators ausgebildet. Das Sicherungsgehäuse wird vorzugsweise aus Porzellan, Gießharz, Epoxidharz oder Keramik hergestellt.

Es wird daher ein integriertes Bauteil zur Verfügung gestellt, das eine Sicherung aufweist, die mit einem kapazitiven Bauelement in Reihe geschaltet ist. Dabei befindet sich das kapazitive Bauelement im Sicherungsgehäuse, so daß für den Schmelzleiter kein eigenes Sicherungsgehäuse mehr benötigt wird. Störende Verbindungsleitungen zwischen Sicherung und kapazitivem Bauelement können so auf ein Mindestmaß beschränkt werden.

Besonders bevorzugt ist eine Ausführungsform, bei der als kapazitives Bauelement ein Scheibenkondensator mit einem vorzugsweise einschichtigem Dielektrikum vorgesehen ist. Mit Vorteil kommen hier Keramikkondenstoren zum Einsatz, bei denen als Dielektrikum eine Keramik verwendet wird. Der Scheibenkondensator weist eine sehr geringe Eigeninduktivität auf. Zwar ist durch Verwendung des Scheibenkondensators die Gefahr eines Spannungsdurchschlages deutlich erhöht, dessen negative Folgen werden jedoch durch das Vorhandensein des Schmelzleiters stark eingeschränkt.

Sicherungsgehäuse sind meist zusätzlich noch mit feinem Quarzsand gefüllt, um eine Lichtbogenausbildung in der durchgeschmolzenen Sicherung zu unterbinden. Aus diesem Grunde ist auch das Gehäuse des kapazitiven Teilers mit Vorteil mit feinem Quarzsand oder ähnlichen gleichwirkenden Materialien gefüllt.

Insbesondere bei der Verwendung eines Scheibenkondensators kann sich aufgrund der hohen Kapazität bzw. der damit verbundenen geringen Abstände der beiden Kondensatorplatten außerhalb des Plattenkondensators im Randbereich ein hohes elektrisches Feld ausbilden. Dieses hohe Streufeld kann unerwünschte Streueffekte auf benachbarte Leitungen oder Bauteile zeigen. Erfindungsgemäß ist daher vorgesehen, das Gehäuse mit einem Fluid zu füllen, dessen elektrische Durchschlagfestigkeit größer ist als die von atmosphärischer Luft und/oder dessen relative Dielektrizitätskonstante εᵣ größer als 1,2, vorzugsweise größer als 1,6, besonders bevorzugt größer als 2 ist. Es versteht sich, daß das Fluid auch zusätzlich zu dem eventuell vorhandenen Quarzsand eingefüllt werden kann. Als Fluid kommt vorzugsweise Luft unter hohem Druck, Öl, Schwefelhexafluorid (SF₆) aber auch Stickstoff in Frage. Es versteht sich, daß unter Fluid sowohl flüssige als auch gasförmige Stoffe verstanden werden.

Alternativ dazu kann es für manche Anwendungsfälle von Vorteil sein, wenn außerhalb des Plattenkondensators an seinen Rändern in etwa im Bereich, der bei aufgeladenem Kondensator die größte Feldstärke aufweist, ein den Plattenkondensator zumindest teilweise umfassender Feststoff angeordnet ist. Da der Feststoff oftmals eine höhere Dielektrizität und eine höhere elektrische Festigkeit zeigt als Fluid, kann durch den Feststoff die Spannungsfestigkeit des kapazitiven Teilers weiter erhöht werden. Auch wenn der Feststoff nicht notwendigerweise den Plattenkondensator völlig umfaßt, so wird er dennoch vorzugsweise ringartig um diesen angeordnet. Dadurch ist gewährleistet, daß die Feldlinien, die außerhalb des Kondensators verlaufen, zumindest in dem Bereich, der die größte Feldstärke zeigt, durch den Feststoff verlaufen. Es versteht sich, daß der Kondensator nicht unbedingt kreisförmige Platten aufweisen muß, sondern beispielsweise auch rechteckige. Im Falle von rechteckigen Platten wird unter der ringartigen Anordnung verstanden, daß der Feststoff den Kondensator in einer Ebene völlig umgibt.

Eine besonders bevorzugte Ausführungsform sieht vor, daß der Feststoff derart angeordnet ist, daß er eine Haltefunktion ausübt, um den Kondensator innerhalb des Gehäuses zu fixieren. Dadurch ist gewährleistet, daß der Kondensator innerhalb des Gehäuses stets an der vorgesehenen Stelle verbleibt und nicht, beispielsweise durch äußere Erschütterungen verursacht, innerhalb des Gehäuses verrutschen kann.

Als Feststoff wird vorzugsweise ein Material verwendet, dessen relative Dielektrizitätskonstante εᵣ größer als 2, vorzugsweise größer als 2,5, besonders bevorzugt größer als 3 ist.

Bevorzugte Ausführungsformen des kapazitiven Teilers sehen vor, daß als Feststoff Silikongummi, Gießharz oder ein Elastomer gewählt wird.

Für manche Anwendungsfälle kann es von Vorteil sein, wenn der Feststoff einstückig mit dem Gehäuse ausgebildet ist. Im Falle von Gießharz bzw. Epoxidharz werden das Gehäuse und der Feststoff aus einem einstückigen Gießling gebildet.

Diese Ausführungsform ist besonders einfach und preisgünstig herzustellen.

Eine weitere bevorzugte Ausführungsform sieht vor, daß der vom Feststoff umgebene Kondensator den Gehäuseinnenraum in zwei Teilräume trennt, wobei der eine Teilraum den Verbindungsleiter aufnimmt. Insbesondere dann, wenn Quarzsand zur Verhinderung eines Lichtbogens vorgesehen ist, kann durch diese Ausführungsform die Menge von benötigtem Quarzsand verringert werden, da nur noch in den Teilraum des Gehäuses Quarzsand eingefüllt werden muß, der den teilweise als Schmelzleiter ausgebildeten Verbindungsleiter aufnimmt. Damit ergibt sich eine Ausführungsform, bei der das als Hohlkörper ausgebildete (Sicherungs-)Gehäuse an seinem einen Kopfende von dem Kondensator verschlossen wird. Dabei können sich jedoch die Wände des Gehäuses über den Kondensator hinaus erstrecken. Der andere Teilraum kann beispielsweise leer bleiben oder zum Einbau von Sekundärkomponenten, wie Überspannungsschutzeinrichtungen oder Anpassungsbausteine für Meß- und Übertragungssysteme, benutzt werden.

Die Wände des anderen Teilraums, der nicht den Verbindungsleiter aufnimmt, sind oftmals zweckmäßig, da dadurch der Abstand zwischen der dem Schmelzleiter abgewandten Kondensatorplatte und des Anschlußkontaktes vergrößert wird, was möglicherweise eine Beeinflussung des Kondensators, beispielsweise durch andere stromführende Leitungen oder die (Erd-)Masse, verringert.

Die Herstellungskosten des kapazitiven Teilers können dadurch weiter verringert werden, daß der Verbindungsleiter im wesentlichen als starres, eigenstabiles Gebilde ausgeführt wird. Im allgemeinen wird zumindest der als Schmelzleiter ausgebildete Teil des Verbindungsleiters auf einen Wikkelkörper gewickelt. Wird jedoch als Material für den Schmelzleiter ein starres im wesentlichen eigenstabiles Material gewählt, so kann auf den Wickelkörper verzichtet werden. Dabei muß das Material zumindest derart starr bzw. eigenstabil sein, daß selbst durch Erschütterungen des gesamten kapazitiven Teilers ein zufälliger Berührungskontakt zwischen benachbarten Wicklungen des Schmelzleiters ausgeschlossen wird.

Die Eigeninduktivität des kapazitiven Teilers kann in einer anderen bevorzugten Ausführungsform dadurch noch weiter verringert werden, daß der Verbindungsleiter mindestens zwei Teilwicklungen aufweist, die derart angeordnet sind, daß die Magnetfelder, die von den beiden Teilwicklungen bei einem sich ändernden Stromfluß durch die Schmelzsicherung induziert werden, sich zumindest teilweise auslöschen.

Besonders bevorzugt weist mindestens eine (Teil-)Wicklung einen Wicklungssinn auf, der zu mindestens einer anderen (Teil-)Wicklung im wesentlichen entgegengesetzt ist.

Dabei versteht es sich, daß eine Wicklung nicht notwendigerweise kreisförmig ausgebildet sein muß. Vielmehr ist es beispielsweise auch möglich, Wicklungen oval oder auch mit einer oder mehreren Ecken vorzusehen. Überdies muß eine Wicklung in der Projektion auf eine Ebene senkrecht zur Wicklungsachse nicht unbedingt eine geschlossene Kurve bilden. Es ist daher auch möglich, daß sich im Falle von wendelförmigen Wicklungen der Durchmesser von Wicklung zu Wicklung oder auch innerhalb einer Wicklung ändert, zudem wird auch unter einer Teilwicklung eine Wicklung im erfindungsgemäßen Sinn verstanden.

Dadurch, daß der Verbindungsleiter mindestens zwei (Teil-)Wicklungen mit entgegengesetztem Wicklungssinn aufweist, ist gewährleistet, daß die Induktivität des teilweise als Schmelzleiters und damit als Schmelzsicherung ausgebildeten Verbindungsleiter herabgesetzt ist. Dabei kommt es im wesentlichen darauf an, daß sich die Magnetfelder, die sich durch Änderungen des Stromflusses innerhalb des Verbindungsleiters bilden, derart überlagern, daß sie sich zumindest zum Teil gegenseitig aufheben bzw. auslöschen. Um eine möglichst geringe Induktivität zu erhalten, werden daher vorzugsweise in etwa die Hälfte der Wicklungen mit einem zu der anderen Hälfte entgegengesetzten Wicklungssinn versehen.

Dabei kann auch der Teil des Verbindungsleiters, der nicht als Schmelzleiter ausgebildet ist, für die Wicklungen verwendet werden.

Eine besonders bevorzugte Ausführungsform sieht vor, daß der Schmelzleiter im wesentlichen wendelförmig angeordnet ist, wobei sich der Wicklungssinn der wendelförmigen Anordnung mindestens einmal umkehrt.

Bei einer besonders bevorzugten Ausführungsform ist der Schmelzleiter auf einen Wickelkörper aufgebracht. Bei der Herstellung des Verbindungsleiters für den kapazitiven Teiler wird dann der Verbindungsleiter bzw. der Schmelzleiter zunächst beispielsweise im Uhrzeigersinn um einen Wikkelkörper gewickelt. Nach etwa der Hälfte der beabsichtigten Wicklungen wird während des Wickelvorganges der Drehsinn bzw. der Wicklungssinn geändert, so daß die zweite Hälfte der Wicklungen entgegengesetzt dem Uhrzeigersinn gewickelt wird. Es versteht sich, daß es auch möglich ist, den Wicklungssinn mehrmals während des Wicklungsvorganges zu ändern. Eine weitere Möglichkeit zur Verwirklichung dieser Ausführungsform besteht darin, zwei wendelförmig gewickelte Schmelzleiter mit entgegengesetztem Wicklungssinn in Reihe entlang einer gemeinsamen (Wicklungs-)Achse auszurichten. Alternativ dazu kann auch ein wendelförmiger Schmelzleiter mit einer entgegengesetzt gewickelten Spule in Reihe geschaltet werden. Dabei löschen sich die induzierten Magnetfelder des Schmelzleiters und der Spule weitgehend aus. Es ist daher nicht notwendig, die Spule ebenfalls als Schmelzleiter auszubilden.

Eine weitere bevorzugte Ausführungsform sieht vor, daß der Verbindungsleiter im wesentlichen mäanderförmig angeordnet ist. Hier besteht der Verbindungsleiter im wesentlichen aus einer Vielzahl von aneinander geketteten Teilwicklungen, die sich jeweils im Wicklungssinn unterscheiden.

Eine weitere besonders zweckmäßige Ausführungsform sieht vor, daß der Schmelzleiter mindestens zwei Abschnitte mit wendelförmigen Wicklungen aufweist, wobei die Wicklungen mindestens eines ersten Abschnittes einen zu den Wicklungen mindestens eines zweiten Abschnittes entgegengesetzten Wicklungssinn aufweisen und die beiden Abschnitte im wesentlichen koaxial zueinander angeordnet sind. Durch diese Anordnung kann die Bauhöhe des gesamten kapazitiven Teilers reduziert werden, was kostensparend in der Herstellung ist. So kann der kapazitive Teiler beispielsweise zwei Wickelkörper aufweisen, einen äußeren als Hohlkörper ausgebildeten Wickelkörper und einen innerhalb des Hohlkörpers angeordneten inneren Wickelkörper, wobei die Wicklungen, die auf dem äußeren Wickelkörper aufgebracht sind, einen Wicklungssinn aufweisen, der dem Wicklungssinn der auf den inneren Hohlkörper aufgebrachten Wicklungen entgegen gesetzt ist. Die beiden Wicklungsabschnitte mit unterschiedlichem Wicklungssinn können sowohl parallel als auch in Reihe geschaltet werden.

Eine besonders bevorzugte Ausführungsform sieht vor, daß die Durchmesser der beiden wendelförmigen Abschnitte im wesentlichen gleich sind, so daß sich die beiden Abschnitte an mindestens einem Punkt berühren, wobei ein elektrischer Kontakt zwischen den beiden Abschnitten an dem Berührungspunkt entsteht. Mit anderen Worten werden die beiden Schmelzleiterabschnitte mit Wicklungen entgegengesetzten Wickelsinns beispielsweise auf die Außenseite desselben Wickelkörpers aufgebracht, wobei die Wicklungen mit dem einen Wicklungssinn direkt auf bzw. direkt unter den Wicklungen mit dem anderen Wicklungssinn verlaufen. Der elektrische Kontakt zwischen beiden Wicklungen mit unterschiedlichem Wicklungssinn ist nicht von Nachteil. Hier werden schaltungstechnisch lediglich zwei Spulen (bzw. Teilwicklungen) mit entgegengesetztem Wicklungssinn, die koaxial zueinander verlaufen, parallel geschaltet. Auch durch diese Maßnahme wird die Eigeninduktivität des kapazitiven Teilers stark herabgesetzt.

Eine weitere zweckmäßige Ausführungsform sieht vor, daß die beiden wendelförmigen Abschnitte einen unterschiedlichen Durchmesser besitzen, wobei der eine Abschnitt an der Außenseite eines als Hohlkörper ausgebildeten Wickelkörpers verläuft und der andere Abschnitt an der Innenseite des als Hohlkörper ausgebildeten Wickelkörpers verläuft.

Diese Anordnung hat den Vorteil, daß lediglich ein Wickelkörper für beide Wendelabschnitte benötigt wird, wobei dennoch sicher gestellt ist, daß keine Berührung zwischen den unterschiedlichen Abschnitten erfolgt. Auch hier können selbstverständlich die beiden Wendelabschnitte sowohl parallel als auch in Reihe geschaltet werden.

Alternativ dazu kann auch eine Ausführungsform vorgesehen sein, bei der sowohl ein Außenwickelkörper als auch ein Innenwickelkörper vorhanden sind, wobei der eine wendelförmige Abschnitt an dem Außenwickelkörper angeordnet ist und der andere wendelförmige Abschnitt mit Wicklungen mit entgegengesetztem Wicklungssinn auf dem Innenwickelkörper angebracht ist.

Es versteht sich, daß der Verbindungsleiter nicht unbedingt aus einem separaten Draht bestehen muß. So ist es für manche Anwendungsfälle von Vorteil, wenn der Verbindungsleiter von einer auf einem Substrat aufgebrachten Leitungsbahn gebildet wird. Der Schmelzleiter kann auf dem Substrat einfach durch die bekannten Beschichtungsverfahren aufgebracht werden. Besonders bevorzugt ist dabei eine Ausführungsform, bei der der Wickelkörper selbst das Substrat für die Beschichtung darstellt, so daß der Schmelzleiter sowohl auf der Innen- als auch auf der Außenseite des als Hohlkörper ausgebildeten Wickelkörpers angebracht werden kann.

Für besonders spezielle Anwendungsfälle kann es von Vorteil sein, daß der kapazitive Teiler eine Vorrichtung zur Veränderung der Eigeninduktivität des kapazitiven Teilers aufweist. So ist es nicht in allen Fällen gewünscht, daß der kapazitive Teiler eine möglichst geringe Eigeninduktivität annimmt, sondern es kann für manche Anwendungsfälle von Vorteil sein, wenn die Induktivität auf einen bestimmten Wert eingestellt werden kann. Dies kann beispielsweise mit Hilfe eines Ferritkerns erfolgen, der zumindest teilweise in den Wickelkörper des Verbindungsleiters hinein ragt. Je nach Ausführungsform kann dann die Induktivität des Verbindungsleiters und damit des kapazitiven Teilers dadurch verändert werden, daß beispielsweise der Ferritkern weiter in den als Hohlkörper ausgebildeten Wickelkörper hinein bzw. heraus geschoben wird. Bei der Ausführungsform mit einem Innenwickelkörper und einem Außenwickelkörper kann alternativ dazu auch vorgesehen werden, daß der Außenwickelkörper und/oder der Innenwickelkörper zumindest teilweise über den Ferritkern geschoben werden kann bzw. können, so daß die Induktivität der Schmelzsicherung dadurch verändert werden kann.

Die vorliegende Erfindung erlaubt es, den kapazitiven Teiler in einem Hochspannungskreis einzusetzen. Unter Hochspannung wird eine Spannung über 1000 V, vorzugsweise zwischen 10 kV und etwa 50 kV, verstanden.

Durch die vorliegende Erfindung ist es darüber hinaus möglich, den kapazitiven Teiler mit einer festen vorbestimmten Induktivität herzustellen. Dies erlaubt es, den kapazitiven Teiler auch als induktives Bauelement in einem Schaltkreis zu verwenden.

Insbesondere bei der Ausführungsform, bei der der im Feststoff eingefaßte Kondensator den Innenraum in zwei Teilräume trennt, wobei der eine Teilraum den Verbindungsleiter aufnimmt, können vorzugsweise in dem anderen Teilraum ein oder mehrere zusätzliche Bauelemente vorgesehen werden.

So weist der kapazitive Teiler in einer besonders zweckmäßigen Ausführungsform, beispielsweise in dem anderen Teilraum, eine Einrichtung zur Auswertung von Störsignalen auf. Diese Störsignale treten üblicherweise durch innere und äußere Teilentladungen in der elektrischen Isolierung von Hochspannungsleitungen und Geräten auf. Durch eine solche Anordnung könnte der kapazitive Teiler zusätzlich zur Überwachung der Isolationsqualität des Hochspannungsnetzes verwendet werden. Dies ist möglich, da das üblicherweise als Störsignal ausgefilterte Frequenzspektrum im Hinblick auf innere Teilentladungen und möglicherweise fortschreitende Schädigung der Isolierung ausgewertet werden kann.

Weitere Vorteile, Merkmale und Anwendungsmöglichkeiten der vorliegenden Erfindung werden deutlich anhand der folgenden Beschreibung bevorzugter Ausführungsformen sowie der dazu gehörigen Figuren. Es zeigen:
- Figur 1: eine schematische Skizze einer ersten Ausführungsform des erfindungsgemäßen kapazitiven Teilers,
- Figur 2: eine schematische Skizze einer zweiten Ausführungsform des kapazitiven Teilers,
- Figur 3: eine dritte Ausführungsform des kapazitiven Teilers,
- Figur 4: eine erste alternative Ausführungsform des Verbindungsleiters,
- Figur 5: eine zweite alternative Ausführungsform des Verbindungsleiters,
- Figur 6: eine dritte alternative Ausführungsform des Verbindungsleiters,
- Figur 7: eine vierte alternative Ausführungsform des Verbindungsleiters,
- Figur 8: eine fünfte alternative Ausführungsform des Verbindungsleiters und
- Figur 9: eine sechste alternative Ausführungsform des Verbindungsleiters.

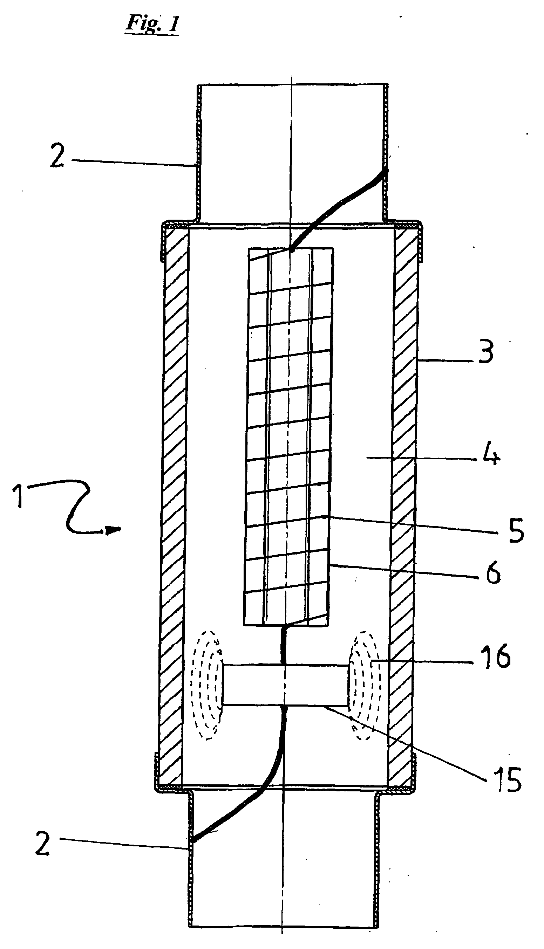

In Figur 1 ist eine erste Ausführungsform des erfindungsgemäßen kapazitiven Teilers 1 gezeigt. Dieser besteht aus einem Isolatorhohlkörper 3 mit zwei Anschlußkontakten 2, wobei der Isolatorhohlkörper 3 einen quarzsandgefüllten Hohlraum 4 aufweist. In dem Hohlraum 4 ist ein Wickelkörper 6 angeordnet, auf dessen Oberfläche der teilweise als Schmelzleiter ausgebildete Verbindungsleiter 5 aufgebracht ist. Der Verbindungsleiter 5 verbindet den oberen Anschlußkontakt 2 mit der oberen Kondensatorplatte des Kondensators 15. Die untere Kondensatorplatte des Kondensators 15 ist mit dem unteren Anschlußkontakt 2 verbunden. Deutlich zu erkennen ist, daß sowohl Verbindungsleiter als auch Kondensator 15 in einem gemeinsamen Gehäuse 3 untergebracht sind.

Wenn der Kondensator 15 aufgeladen ist, so entsteht nicht nur zwischen den Kondensatorplatten ein elektrisches Feld, sondern auch außerhalb des Kondensators kann ein elektrisches Feld beobachtet werden. Dieses ist insbesondere an den Randbereichen des Kondensators am größten. Dies ist schematisch durch die gestrichelten Linien 16 gezeigt, die die Feldlinien des elektrischen Felds darstellen sollen.

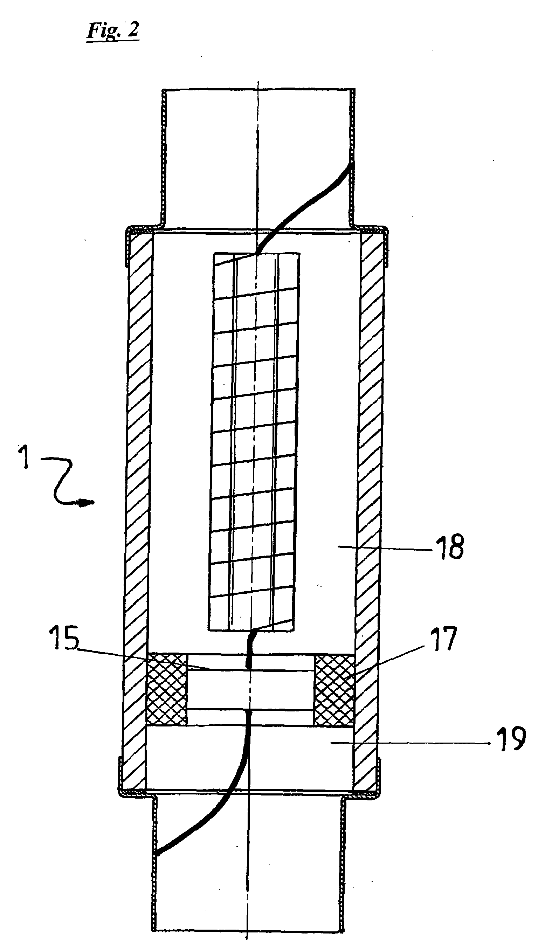

In Figur 2 ist eine alternative Ausführungsform des kapazitiven Teilers dargestellt. Hierbei ist der Kondensator 15 von einem Feststoff 17 umgeben, der den Kondensator 15 fixiert, wobei der Feststoff in dem Bereich angeordnet ist, in dem außerhalb des Kondensators die größte Feldstärke herrscht.

Dadurch wird der Hohlraum 4 des Isolatorhohlkörpers 3 in zwei Teilräume 18 und 19 geteilt. Der Teilraum 18 ist mit Quarzsand gefüllt und nimmt den teilweise als Schmelzsicherung ausgebildeten Verbindungsleiter 5 auf. Der Teilraum 19 ist, abgesehen von einer Anschlußleitung, die die untere Kondensatorplatte des Kondensators 15 mit dem unteren Anschlußkontakt verbindet, leer.

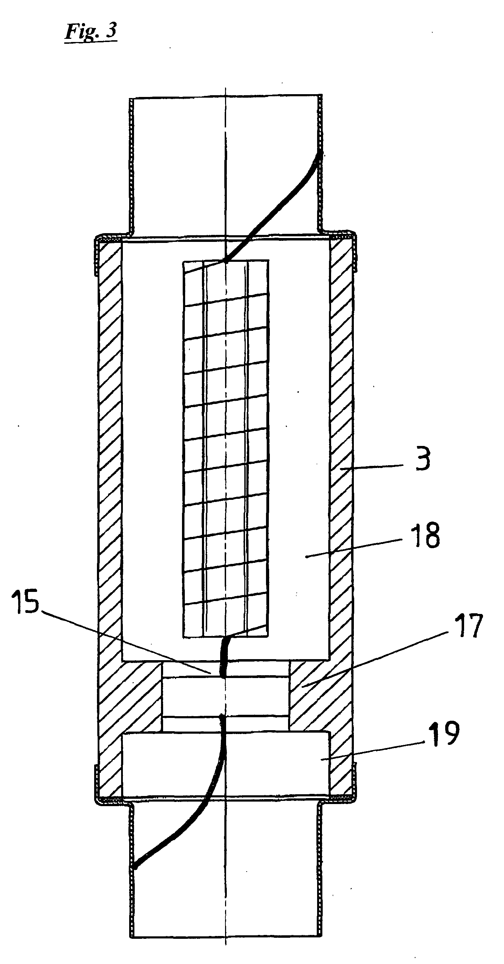

In Figur 3 ist eine dritte Ausführungsform des kapazitiven Teilers gezeigt. Hier ist der Feststoff 17 einstückig mit dem Hohlkörper 3 verbunden. Auch hier wird der Hohlraum in zwei Teilräume 18 und 19 geteilt. Der Teilraum 19 ist auch in dieser Ausführungsform leer gelassen, obgleich hier weitere Bauelemente vorgesehen werden können.

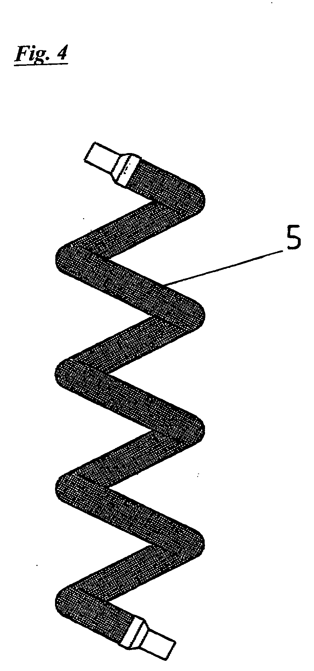

In den Figuren 4 bis 9 sind unterschiedliche Ausführungsformen des Verbindungsleiters 5 dargestellt. Zur Vereinfachung wurde auf eine Darstellung des Verbindungsleiters 5 zusammen mit dem Kondensator 15 in einem Gehäuse verzichtet. Erfindungsgemäß müssen jedoch die in den Figuren 4 bis 9 gezeigten Verbindungsleiter 5 innerhalb eines Gehäuses zusammen mit dem Kondensator 15 angeordnet werden.

In Figur 4 ist eine besondere Ausführungsform des Verbindungsleiters 5 gezeigt. Deutlich zu erkennen ist, daß der Verbindungsleiter 5 wendelförmig angeordnet ist, ohne daß er auf einen Wickelkörper aufgebracht ist. Der Verbindungsleiter 5 muß dafür aus einem starren Material gefertigt sein, so daß die wendelförmige Anordnung beibehalten wird, auch wenn der kapazitive Teiler Erschütterungen ausgesetzt ist.

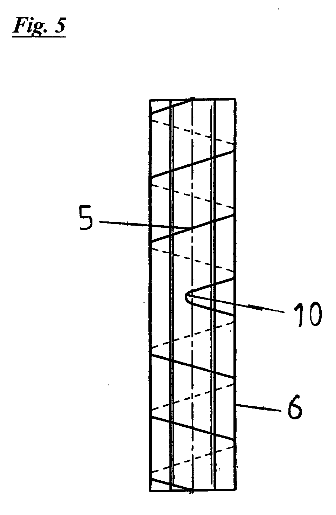

Figur 5 zeigt eine alternative Ausführungsform des Verbindungsleiters 5. Der Verbindungsleiter ist in dieser Ausführungsform auf einen Wickelkörper 6 aufgebracht. Deutlich zu erkennen ist, daß der Verbindungsleiter 5 in etwa in der Mitte einen Wendepunkt 10 aufweist. An diesem Wendepunkt 10 ändert der Verbindungsleiter seinen Wicklungssinn. Durch diese Wendewicklung wird die Eigeninduktivität des Verbindungsleiters 5 und damit des kapazitiven Teilers deutlich herabgesetzt. Während der Herstellung des Verbindungsleiters 5 muß beim Wickeln des Verbindungsleiters 5 auf den Wickelkörper 6 lediglich zwischenzeitlich die Wickelrichtung geändert werden. Es versteht sich, daß auch möglich ist, die Wickelrichtung mehrmals zu ändern, so daß eine Mehrzahl von Wendepunkten 10 entsteht. Erfindungsgemäß ist dabei darauf zu achten, daß die Induktivität des kapazitiven Teilers möglichst gering wird. Dies wird dadurch erreicht, daß in etwa die gleiche Anzahl von Wicklungen einen zu der anderen Hälfte von Wicklungen entgegengesetzten Dreh- bzw. Wicklungssinn hat. Selbstverständlich ist es auch erfindungsgemäß ebenfalls möglich, das Verhältnis der Anzahl der Wicklungen mit einem Wicklungssinn zu der Anzahl der Wicklungen mit dem anderen Wicklungssinn nicht 1 : 1 zu wählen, um eine definierte Induktivität des kapazitiven Teilers zu erzielen.

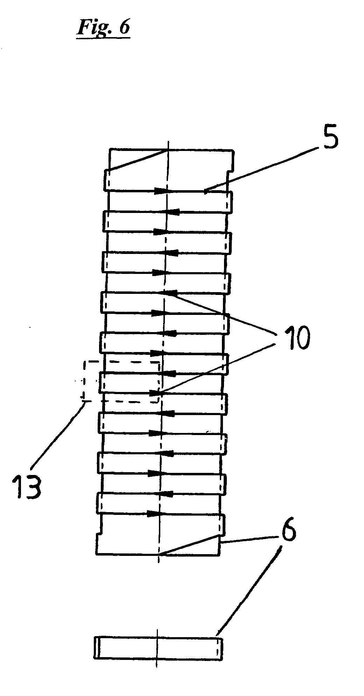

Eine zweite alternative Ausführungsform der Wicklung des Verbindungsleiters 5 ist in Figur 6 gezeigt. Hier ist der Wickelkörper 6 nicht rotationssymmetrisch, sondern besteht aus einem langen schmalen Quader, wie aus der Querschnittsansicht des Wickelkörpers unten in Figur 6 ersichtlich ist. Auf diesen Wickelkörper 6 ist der Verbindungsleiter 5 mäanderförmig aufgebracht. Die Mäanderform kann als alternierende Folge von Halbwicklungen mit jeweils umgekehrtem Richtungssinn aufgefaßt werden. Beispielhaft ist eine Halbwicklung durch den Bereich 13 gekennzeichnet worden. Die Pfeile deuten jeweils die Wicklungsrichtung an. Die Teilwicklungen mit unterschiedlichem Wicklungssinn sind an den Wendepunkten 10 miteinander verbunden.

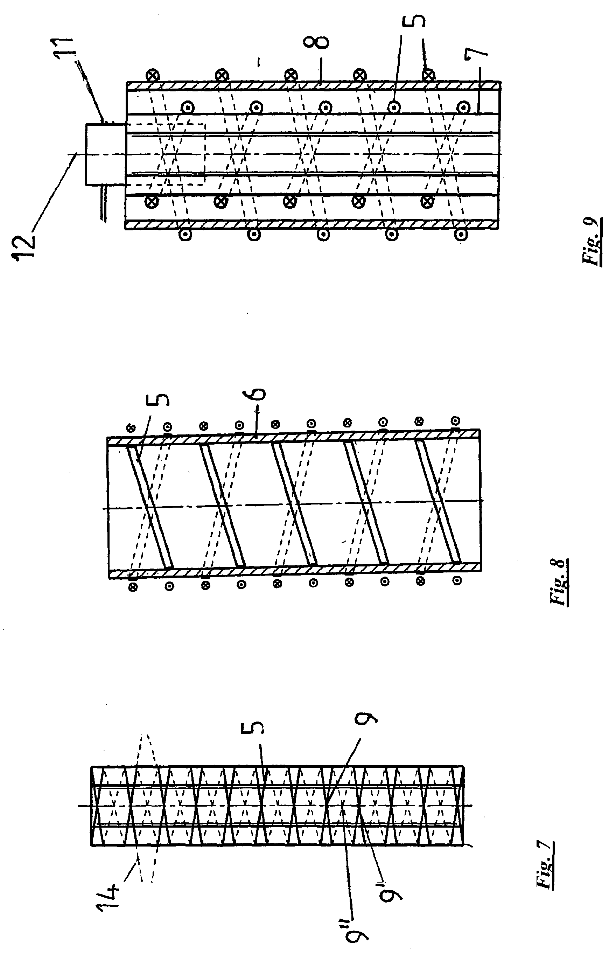

In Figur 7 ist eine dritte alternative Ausführungsform der Wicklung des Verbindungsleiters 5 gezeigt. Hier verläuft der Verbindungsleiter zunächst wendelförmig über die ganze Länge des Wickelkörpers 6 mit gleichem Wicklungssinn. An einem Ende des Wickelkörpers (nicht gezeigt) befindet sich ein Wendepunkt, an dem sich der Wicklungssinn des Verbindungsleiters 5 ändert, so daß der Schmelzleiter mit entgegengesetztem Wicklungssinn dann erneut über die ganze Länge des Wickelkörpers 6 wendelförmig verläuft. Dadurch ergeben sich zwangsläufig Berührungspunkte 9 zwischen Wicklungen mit dem einen Wicklungssinn und Wicklungen mit dem anderen Wicklungssinn. Zwar ist es möglich, den Verbindungsleiter bzw. den Schmelzleiter 5 zu isolieren, so daß an den Berührpunkten 9 kein elektrischer Kontakt entsteht, dies ist jedoch nicht unbedingt erforderlich. In diesem Fall kann beispielsweise die Verbindung zwischen den Punkten 9 und 9" schaltungstechnisch als Parallelschaltung zweier Teilwicklungen mit entgegengesetztem Wicklungssinn aufgefaßt werden. Fließt ein zu hoher Strom durch den kapazitiven Teiler, so wird die Schmelzsicherung ausgelöst, d. h., der Schmelzleiter wird an einem der Berührpunkte 9, 9', 9" aufgetrennt, da hier die größte Wärmeentwicklung stattfindet. Daher ist bei der Anordnung der Wicklungen darauf zu achten, daß die Berührpunkte 9 und 9', die auf derselben Seite des Wickelkörpers angeordnet sind, einen genügend großen Abstand aufweisen, damit das beispielsweise in Berührpunkt 9 aufgetrennte freie Ende nicht mit dem noch intakten Berührpunkt 9' in Berührung kommen kann und somit die bereits ausgelöste Sicherung wieder leitfähig machen kann.

An diesem Beispiel wird deutlich, daß der Verbindungsleiter 5 nicht unbedingt aus einem gewickelten Draht bestehen muß. Es ist z. B. auch möglich, daß der Draht auf dem Wickelkörper mit Hilfe eines der bekannten Beschichtungsverfahren aufgebracht wird. Eine andere Möglichkeit besteht darin, auf dem Wickelkörper eine Metallfolie anzuordnen, die rautenförmige Ausstanzungen aufweist, wie beispielhaft durch die mit der Bezugszahl 14 versehene Raute angedeutet wurde.

In Figur 8 ist eine vierte Ausführungsform der Wicklung des Verbindungsleiters 5 zu sehen. Hier befinden sich die Wicklungen sowohl außerhalb als auch innerhalb eines Wickelkörpers 6. Die innerhalb des Wickelkörpers 6 geführten Wicklungen sind in Figur 8 mit durchgezogener Linie dargestellt, während die Wicklungen außerhalb des Wickelkörpers 6 mit unterbrochenen Linien dargestellt sind. Dabei haben die Wicklungen, die sich außerhalb des Wickelkörpers 6 befinden, einen zu den Wicklungen, die sich innerhalb des Wickelkörpers 6 befinden, entgegengesetzten Wicklungssinn. Dies wird durch die Zeichen ⊕ und ⊙ verdeutlicht. Dabei steht ⊕ für eine in die Papierebene hineinführende Richtung und ⊙ für eine aus der Papierebene herausführende Richtung.

Auch hier ist es beispielsweise möglich, den Verbindungsleiter 5 durch geeignete Beschichtungsverfahren direkt auf den als Substrat ausgebildeten Wickelkörper 6 aufzubringen, so daß sich entlang der Außen- und der Innenfläche des als Hohlkörper ausgebildeten Wickelkörpers 6 Leiterbahnen bilden, die sich in ihrem Wicklungssinn unterscheiden.

Schließlich ist in Figur 9 eine fünfte Ausführungsform der Wicklung des Verbindungsleiters 5 gezeigt. Dabei ist sowohl ein innerer Wickelkörper 7 als auch ein äußerer Wickelkörper 8 vorgesehen. Die Wicklungen auf dem äußeren Wickelkörper 8 haben einen zu den Wicklungen auf dem inneren Wikkelkörper 7 entgegengesetzten Wicklungssinn. Mit anderen Worten ist auf dem äußeren Wickelkörper 8 eine wendelförmige Wicklung mit einem festen Durchmesser und Wicklungssinn angebracht, während auf dem inneren Wickelkörper 7 eine wendelförmige Wicklung mit kleinerem Durchmesser und entgegengesetztem Wicklungssinn angeordnet ist. Zusätzlich ist hier ein Ferritkern 11 zu erkennen.

In der hier gezeigten Ausführungsform kann der innere Wickelkörper 7 entlang der Längsachse 12 bewegt werden, so daß er hülsenartig über den Ferritkern 11 geschoben werden kann. Durch das teilweise Eintauchen des Ferritkerns in dem inneren Wickelkörper 7 findet eine teilweise Verstärkung des induktiven Effektes der Wicklungen statt. Durch diese Maßnahme kann die Induktivität des kapazitiven Teilers 1 leicht eingestellt werden. Dies eröffnet den erfindungsgemäßen kapazitiven Teilern ein weites Anwendungsgebiet, da das hierdurch erstmals möglich ist, die erfindungsgemäßen kapazitiven Teiler auch als induktives Bauteil einzusetzen.

Mit der vorliegenden Erfindung ist es auf einfache kostengünstige Weise möglich, Hochspannungskreise effektiv zu überwachen.

Die Erfindung gestattet ferner eine besonders günstige Anwendung insofern, als man Fehler von Kabeln abnehmen und feststellen kann. Wenn also zum Beispiel ein Übertragungskabel innere Entladungen hat, die von einem inneren Fehler herrühren, dann entstehen hochfrequente Störsignale. Bei der Datenübertragung stören solche Signale und müssen herausgefiltert werden. Parallel dazu kann man nun mit den erfindungsgemäßen Maßnahmen im Hinblick auf den Zustand des Übertragungskabels diese Störsignale auswerten.

Herkömmlich erfolgte eine Anbindung über einen kleinen Kondensator im labormäßigen Aufbau, während erfindungsgemäß ein kapazitiver Wandler verwendet werden kann, um die Störsignale zu erfassen.

Der Aufbau dieser zweckmäßigen Anwendung läßt sich so beschreiben, daß ein Verstärker die Spannung über einem Widerstand abgreift und das Signal einem Filter zuführt. Letzterem ist ein A/D-Wandler und diesem wiederum ein PC nachgeschaltet.

### Bezugszeichenliste

- 1: kapazitiver Teiler
- 2: Anschlußkontakte
- 3: Gehäuse, Isolatorhohlkörper
- 4: quarzsandgefüllter Hohlraum
- 5: Verbindungsleiter, Schmelzleiter
- 6: Wickelkörper
- 7: innerer Wickelkörper
- 8: äußerer Wickelkörper
- 9, 9', 9": Berührungspunkt
- 10: Wendepunkt
- 11: Ferritkern
- 12: Längsachse
- 13: Halbwicklung
- 14: Ausstanzung
- 15: Kondensator
- 16: Feldlinien
- 17: Feststoff
- 18: erster Teilraum
- 19: zweiter Teilraum

## Patentansprüche

1. Kapazitiver Teiler mit zwei Anschlußkontakten (2) und einem Gehäuse (3), in welchem ein die beiden Anschlußkontakte (2) verbindendes kapazitives Bauelement (15) vorgesehen ist, **dadurch gekennzeichnet, daß** ein Verbindungsleiter (5) vorgesehen ist, der zumindest teilweise als Schmelzleiter (5) ausgebildet ist und der das kapazitive Bauelement (15) mit einem Anschlußkontakt (2) verbindet.

2. Kapazitiver Teiler nach Anspruch 1, **dadurch gekennzeichnet, daß** das Gehäuse (3) als Sicherungsgehäuse (3) in Form eines als Hohlkörper (3) ausgebildeten Isolators vorgesehen ist.

3. Kapazitiver Teiler nach Anspruch 1 oder 2, **dadurch gekennzeichnet, daß** als kapazitives Bauelement (15) ein Scheibenkondensator (15) mit einem, vorzugsweise einschichtigen, Dielektrikum vorgesehen ist.

4. Kapazitiver Teiler nach einem der Ansprüche 1 bis 3, **dadurch gekennzeichnet, daß** das Gehäuse mit einem Fluid gefüllt ist, dessen relative Dielektrizitätskonstante εᵣ größer als 1,2, vorzugsweise größer als 1,6, besonders bevorzugt größer als 2 ist.

5. Kapazitiver Teiler nach Anspruch 3 oder 4, **dadurch gekennzeichnet, daß** außerhalb des Plattenkondensators (15) an seinen Rändern etwa im Bereich, der bei aufgeladenem Kondensator die größte Feldstärke aufweist, ein den Plattenkondensator (15) zumindest teilweise umfassender Feststoff (17) angeordnet ist.

6. Kapazitiver Teiler nach Anspruch 5, **dadurch gekennzeichnet, daß** der Feststoff (17) derart angeordnet ist, daß er eine Haltefunktion ausübt, um den Kondensator (15) innerhalb des Gehäuses (3) zu fixieren.

7. Kapazitiver Teiler nach Anspruch 5 oder 6, **dadurch gekennzeichnet, daß** als Feststoff (17) ein Material verwendet wird, dessen relative Dielektrizitätskonstante εᵣ größer als 2, vorzugsweise größer als 2,5, besonders bevorzugt größer als 3 ist.

8. Kapazitiver Teiler nach einem der Ansprüche 5 bis 7, **dadurch gekennzeichnet, daß** als Feststoff (17) ein Material oder mehrere Materialien aus der Gruppe, die Silikongummi, Gießharz und Elastomer umfaßt, vorgesehen ist.

9. Kapazitiver Teiler nach einem der Ansprüche 5 bis 8, **dadurch gekennzeichnet, daß** der Feststoff (17) einstückig mit dem Gehäuse (3) ausgebildet ist.

10. Kapazitiver Teiler nach einem der Ansprüche 6 bis 9, **dadurch gekennzeichnet, daß** der im Feststoff (17) eingefaßte Kondensator (15) den Gehäuseinnenraum (4) in zwei Teilräume (18, 19) trennt, wobei der eine Teilraum (18) den Verbindungsleiter (5) aufnimmt.

11. Kapazitiver Teiler nach Anspruch 10, **dadurch gekennzeichnet, daß** der andere Teilraum (19) für die Anordnung weiterer Bauelemente vorgesehen ist.

12. Kapazitiver Teiler nach einem der Ansprüche 1 bis 11, **dadurch gekennzeichnet, daß** der Verbindungsleiter (5) im wesentlichen als starres, eigenstabiles Gebilde ausgeführt ist.

13. Kapazitiver Teiler nach einem der Ansprüche 1 bis 12, **dadurch gekennzeichnet, daß** der Verbindungsleiter (5) mindestens zwei Teilwicklungen aufweist, die derart angeordnet sind, daß die Magnetfelder, die von den beiden Teilwicklungen bei einem sich ändernden Stromfluß durch den Verbindungsleiter (5) induziert werden, sich zumindest teilweise auslöschen.
